# EUROPEAN PATENT APPLICATION

(11) **EP 1 392 089 A1**
(43) Date of publication of application: **25.02.2004**
(21) Application number: 02255849.8
(22) Date of filing: 21.08.2002
(51) Int. Cl.: H05K 1/11, H05K 3/34, H01L 21/60

(54) **Printed circuit board with self align bonding pads thereon**

(71) Applicant: Ultratera Corporation, Hsin-Chu (TW)
(72) Inventor: Maa, Chong-Ren, Taipei (TW); Chih, Wan-Kuo, Hsinchu (TW); Tsou, Ching-Hua, Yunghe City, Taipei (TW)
(74) Representative: O'Connell, David Christopher

(57) **Abstract**

A printed circuit board (PCB), which has bonding pads (21) thereon for mounting a flip chip, comprises a substrate (10) having a conductor pattern (20), which is composed of a plurality of traces in a specific layout. A solder mask (30) is provided on the substrate (10) sheltering the conductor pattren (20). The solder mask (30) is provided with vias (31) to expose the conductor pattern (20) at predetermined portions, and pad layers (40) are provided on the side walls of the vias (31) of the solder mask (30) respectively and are electrically connected with the conductor pattern (20) at the portions exposed via the vias (31) respectively to form the bonding pads (21) of the printed circuit board. Such that when the flip chip (70) has solder bump (71) injected into the bonding pads (21), the solder bumps (71) will be filled therein and fixedly connected with the pad layers (40) to couple the flip chip (70) with the PCB in a fixedly status.

## Description

### FIELD OF THE INVENTION

The present invention relates to an electronic product, and more particularly to a printed circuit board (PCB) with self align bonding pads thereon.

### BACKGROUND OF THE INVENTION

In the present electronic industry, the direct chip attach (DCA) method or the chip size package (CSP) is more popular to manufacturers to mount flip chips on substrates or printed circuit boards (PCB). Photo development method is applied to the solder mask of the substrate or the PCB to provide vias thereon, and then plate Ni-Au layers respectively on the exposed portions of the conductor pattern to form bonding pads for solder bumps can be injected thereon to couple the flip chip with the substrate. There, however, will be a deviation when attaching the photo mask on the substrate, so the vias might shift a predetermined distance from the positions where they are designed.

In prior art, there were two methods to fix the shifting of the vias on the solder mask of the substrate, which are solder mask define method and non-solder mask define method. The solder mask define method is to provide wider bonding pads to cover the shift of the vias and the non-solder mask define method is to provide larger vias to expose the bonding pads with larger areas. Thus, a flip chip can be mounted on the substrate with solder bumps coupling the flip chip with the substrate and the flip chip is electrically connected with the bonding pads via the solder bumps.

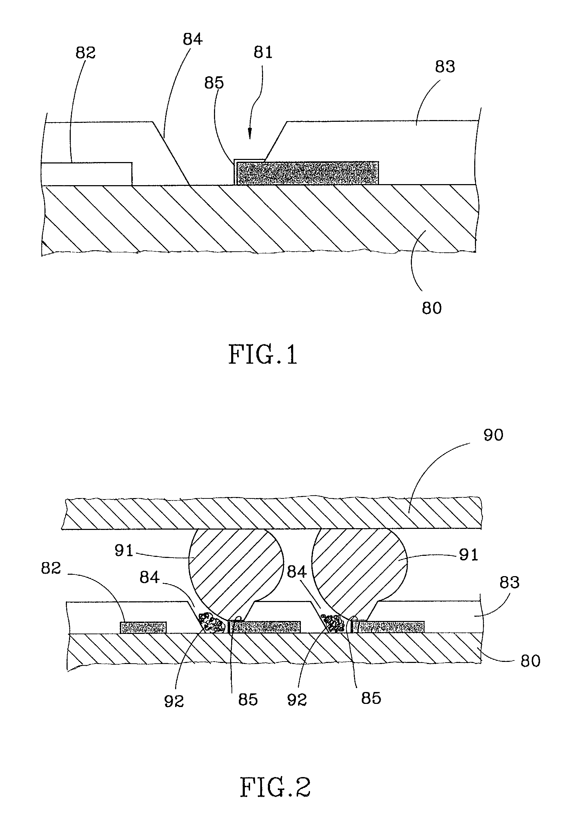

FIG. 1 shows two bonding pads 81 on a substrate 80 which is made from the non-solder mask define method. The substrate 80 has a conductor pattern 82 thereon and a solder mask 83 applied on the substrate 80 to shelter the conductor pattern 82. The solder mask 83 is provided with vias 84 to expose the conductor pattern 82 at specific portions. Each exposed portion of the conductor pattern 82 via the vias 84 is plated a Ni-Au layer 85 thereon to form the bonding pads 81. FIG. 1 also shows the vias 84 shifting a distance, so that the bonding pads 81 are located at sides of the vias 84 respectively.

FIG. 2 shows a flip chip 90 is mounted on the substrate 80 with solder bumps 91 connected with the bonding pads 81. It is easy to understand that if the vias 84 shift a larger distance, the bonding pads 81 will have smaller areas exposed via the vias 84. Thus, the solder bumps 91 will have a weak capacity to couple the flip chip 90 with the substrate 80. So the substrates 80 have a higher proportions of defective in manufacture.

Furthermore, the pad pitch between the bonding pads 81 must be enlarged which will make the flip chip 90 only can be designed with fewer solder bumps 91 thereon or the size of the flip chip 90 must be enlarged to get more solder bumps 91 thereon to meet the numbers and the pitches of the bonding pads 81 on the substrate 80.

After mounting the flip chip 90 onto the substrate 80, the solder bumps 91 will electrically connect the flip chip 90 and the conductor pattern 82 of the substrate 80 via the bonding pads 81. But sometime the residue of flux 92 will be remained in the vias 84 and they are hard to be cleaned.

The bonding pads of the substrates made from the solder mask define method will have the same problems as described above.

### SUMMARY OF THE INVENTION

The primary objective of the present invention is to provide a PCB having bonding pads thereon, which will overcome the drawbacks as described above.

According to the objective of the present invention, a printed circuit board (PCB), which has bonding pads thereon, comprises a substrate having a conductor pattern. The conductor pattern is composed of a plurality of traces in a specific layout. A solder mask is provided on the substrate sheltering the conductor pattern. The solder mask is provided with vias to expose the conductor pattern at predetermined portions, and pad layers are provided on the side walls of the vias of the solder mask respectively and are electrically connected with the conductor pattern at the portions exposed via the vias respectively to form the bonding pads of the printed circuit board. Such that when a flip chip having solder bumps injected into the bonding pads, the solder bumps will be filled therein and fixedly connected with the pad layers to couple the flip chip with the PCB in a fixedly status.

### BRIEF DESCRIPTION OF THE DRAWINGS

FIG. 1 is a sectional view of a conventional substrate;
FIG. 2 is a sectional view of the conventional substrate, showing a flip chip mounted on the substrate;
FIG. 3 is a sectional view of a prefer embodiment of the present invention;
FIG. 4 is a sectional view of the prefer embodiment of the present invention, showing a flip chip being mounted on the PCB;
FIG. 5 is a schematic view, showing how to manufacture the bonding pads of the prefer embodiment of the present invention, and
FIG. 6 is a schematic view, showing another way to manufacture the bonding pads of the prefer embodiment of the present invention.

### DETAIL DESCRIPTION OF THE INVENTION

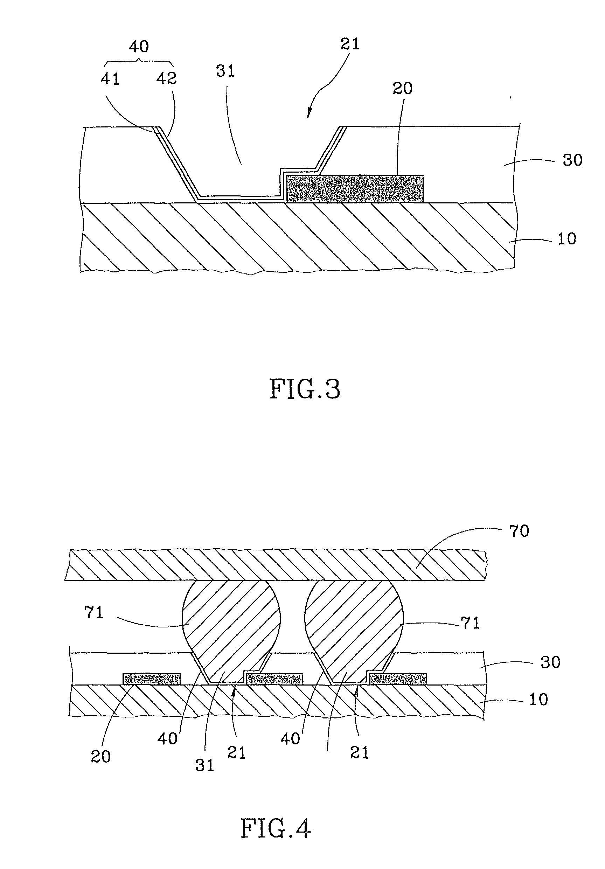

Please refer to FIG. 3, the prefer embodiment of the present invention provides a printed circuit board (PCB) comprising:

A substrate 10 is made of base material, such as multi-function epoxy resin in the present invention, The substrate 10 has a conductor pattern 20, which is composed of a plurality of copper traces in a specific layout, thereon. The PCB of the present invention can be a single-layer PCB or a multi-layer PCB.

A solder mask 30, which is made of multi-function epoxy resin, is applied on the substrate 10 sheltering the conductor pattern 20. The solder mask 30 is provided with vias 31 thereon to expose the conductor pattern 20 at predetermined portions. FIG. 3 shows the vias 31 are shifted a distance because of the error occurred in photo development method being applied to form the vias 31 so that the copper traces of the conductor pattern 20 only have parts thereof exposed via the vias 31.

Pad layers 40 are respectively provided on the side walls of the vias 31 and on the exposed portions of the conductor pattern 20. Each pad layer 40 has an inner layer 41 which can be a copper layer attached on the side wall of the via 31, the surface of the exposed copper trace and sometime it has a part attached on the substrate 10, and an outer layer 42 which can be a Ni-Au layer attached on the inner layer 41. The pad layers 40 are electrically connected with the conductor pattern 20 to form bonding pads 21.

The advantages of the present invention are:
1. The locations of the vias 31 will be accepted that the conductor patterns 20 has any parts thereof exposed via the vias 31 for the pad layers 40 can touch the conductor pattern 20. So that I call them "self align bonding pads". Thus, the present invention will have a tolerance of the photo mask (not shown) attached on the solder mask 30 larger than the conventional ways have, so that the PCB of the present invention will has a lower proportion of defective in manufacture.
2. Please refer to FIG. 4, the locations of the bonding pads 21 of the present invention are the locations of the vias 31 rather than the exposed parts of the conductor pattern 20 via the vias 31. So, the present invention will fix the problems of the conventional bonding pads as described in the background. The areas of the bonding pads 21 of the present invention are substantially equal to the whole vias 31 which are larger than the areas of the conventional bonding pads. So that when mounting a flip chip 70 onto the substrate 10, solder bumps 71 will be respectively attached on the whole areas of the pad layers 40 to provide a superior capacity to couple the flip chip 70 with the substrate 10. Furthermore, the solder bumps 71 will be filled in the vias 31 so that there will be no residue of flux left.
3. It dose not have to provide the copper traces of the conductor pattern 20 with larger widths nor it does not have to provide the vias 31 with larger diameters like the conventional processes did. The diameters of the vias 31 of the present invention can be substantially equal to the widths of the copper traces of the conductor pattern 20, such that the pad pitch of the bonding pads 21 of the present invention is smaller than the conventional bonding pads. Thus, the substrate 10 and the flip chip 70 can be made in smaller sizes.

Hereunder we disclose two processes to manufacture the PCB of the present invention.

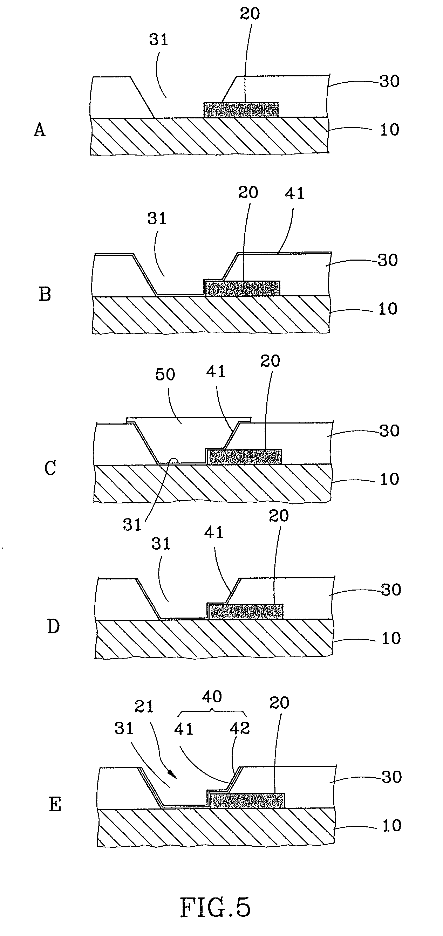

Please refer to FIG. 5, the first process to manufacture the PCB of the present invention has the steps of:
A. Prepare the substrate 10 with the conductor pattern 20 thereon and the solder mask 30 is coated on the substrate 10 sheltering the conductor pattern 20. The solder mask 30 is provided with vias 31 to expose the conductor pattern 20 at specific portions.
B. Chemical plate an electroless copper layer 41 on the solder mask 30. The electroless copper layers 41 are attached on the side walls of the vias 31, the exposed portions of the conductor pattern 20 and sometime it might be attached on the substrate 10 when the vias 31 are shifted for a larger distance.
C. Apply masking layers 50 tenting the vias 31 and then remove the exposed electroless copper layer 41.
D. Remove the masking layers 50.
E. Plate Ni-Au layers 42 on the residue electroless copper layers 41 respectively. Thus, the electroless copper layers 41 and the Ni-Au layers 42 will be the pad layers 40 as described above.

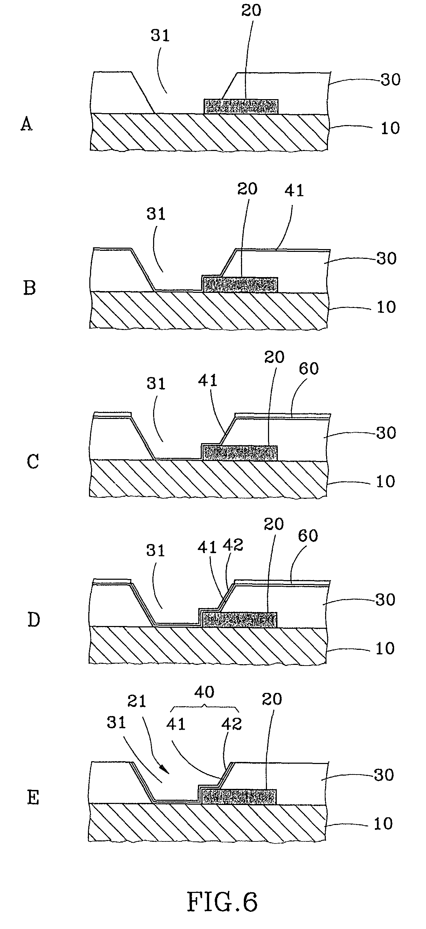

The second process, please refer to FIG. 6, to manufacture the PCB of the present invention has the steps of:
A. Prepare the substrate 10 with the conductor pattern 20 thereon and the solder mask 30 is coated on the substrate 10 sheltering the conductor pattern 20. The solder mask 30 is provided with vias 31 to expose the conductor pattern 20 at specific portions.
B. Chemical plate an electroless copper layer 41 on the solder mask 30, the side walls of the vias 31, the exposed portions of the conductor pattern 20 and sometime it might be attached on the substrate 10.
C. Apply a masking layer 60 on the solder mask 30 and expose the vias 31.
D. Plate Ni-Au layers 42 on the exposed electroless copper layer 41.
E. Remove the masking layer 60 and the exposed electroless copper layer 41. Thus, the electroless copper layers 41 and the Ni-Au layers 42 will be the pad layers 40 as described above.

Specially, it must be mentioned that the outer layers 42 can be made from chemical plating electroless Ni-Au layers. The electroless Ni-Au layers, however, are thinner so that if one wants thicker outer layers 42, one can plate another electrolytic Au layers on the electroless Ni-Au layers. Of course, one can plat electrolytic Ni-Au layers on the inner layers 41 directly to get thicker outer layers 42.

The bonding pads of the PCB of the present invention are used to connect the PCB with another circuit, they are not limited in use of mounting the flip chips only as described in specification.

## Claims

1. A printed circuit board with bonding pads thereon, comprising:
a substrate having a conductor pattern which is composed of a plurality of traces in a specific layout;
a solder mask provided on said substrate sheltering said conductor pattern, said solder mask provided with vias to expose said conductor pattern at predetermined portions, and
pad layers respectively provided on the side walls of said vias of said solder mask and electrically connected with said conductor pattern at the portions exposed via said vias to form said bonding pads of said printed circuit board.

2. According to the printed circuit board as defined in claim 1, wherein said pad layer comprises an inner layer attached on the side wall of said via of said solder mask and the exposed part of said conductor pattern and an outer layer attached on said inner layer.

3. According to the printed circuit board as defined in claim 2, wherein said inner layer of said pad layer is a copper layer.

4. According to the printed circuit board as defined in claim 2, wherein said outer layer of said pad layer is a Ni-Au layer.

5. According to the printed circuit board as defined in claim 1, wherein the exposed portions of said conductor pattern are located sides of said vias of said solder mask respectively and said pad layers have parts attached on said substrate.

6. According to the printed circuit board as defined in claim 2, wherein the exposed portions of said conductor pattern are located sides of said vias of said solder mask respectively and said inner layers of said pad layers have parts attached on said substrate.

7. According to the printed circuit board as defined in claim 1, wherein said solder mask is made of epoxy resin.

8. According to the printed circuit board as defined in claim 1, wherein said substrate is made of epoxy resin.

9. According to the printed circuit board as defined in claim 1, wherein the diameters of said vias of said solder mask are about equal to the widths of said traces of said conductor pattern.
